# EUROPEAN PATENT SPECIFICATION

(11) **EP 4 746 133 B1**
(45) Date of publication and mention of the grant of the patent: **09.12.2026**
(21) Application number: 25159198.8
(22) Date of filing: 20.02.2025
(51) Int. Cl.: H01M 10/6567, H01M 10/42, H01M 10/617, H01M 10/637, H01M 10/659, H01M 50/209, H01M 50/264

(54) **IMMERSION LIQUID-COOLING DEVICE, ENERGY STORAGE SYSTEM AND HEAT MANAGEMENT METHOD**
IMMERSIONSFLÜSSIGKEITSKÜHLVORRICHTUNG, ENERGIESPEICHERSYSTEM UND WÄRMEVERWALTUNGSVERFAHREN
DISPOSITIF DE REFROIDISSEMENT PAR IMMERSION DE LIQUIDE, SYSTÈME DE STOCKAGE D'ÉNERGIE ET PROCÉDÉ DE GESTION DE CHALEUR

(30) Priority: 14.11.2024 CN 202411629231
(43) Date of publication of application: 20.05.2026
(73) Proprietor: Zhejiang Jinko Energy Storage Co., Ltd., Jiaxing, Zhejiang 314415 (CN)
(72) Inventor: WEN, Junyun, Haining City (CN)
(74) Representative: Balder IP Law, S.L.

(56) References cited:
- WO-A1-2024/082731
- CN-A- 116 130 826
- CN-U- 217 884 238
- CN-U- 220 963 498

## Description

### TECHNICAL FIELD

The embodiments of the present disclosure relate to the technical field of heat dissipation for energy storage systems, and in particular to an immersion liquid-cooling device, an energy storage system, and a heat management method.

### BACKGROUND

With the continuous development of industrial technology, the demand for energy is increasing, and various new energy sources have been widely and practically applied. The importance of energy storage is also gradually increasing. An energy storage system can store electrical energy using battery modules and output the stored electrical energy when needed. Since the energy storage system needs to be controlled at an appropriate temperature during operation, it is necessary to dissipate heat from the energy storage system.

The energy storage system generally contains a large number of battery modules, and the temperature of these battery modules during operation determines the working performance of the energy storage system. CN217884238U discloses an immersion liquid-cooling device for an energy storage system, according to the preamble of the appended claim 1.

### SUMMARY

The embodiments of the present disclosure provide an immersion liquid-cooling device, an energy storage system, and a heat management method, which are beneficial to control of the temperatures of the battery modules in the energy storage system.

The immersion liquid-cooling device includes a box body, a fluid circulation structure, and a liquid level adjustment structure. The box body has a plurality of liquid-cooling spaces sequentially formed along a predetermined direction and isolated from each other, each liquid-cooling space of the plurality of liquid-cooling spaces is configured to accommodate at least one respective battery module. The fluid circulation structure is connected to the box body and includes a liquid-inlet pipeline for supplying a coolant, a series-flow pipeline for transferring the coolant, and a liquid-outlet pipeline for discharging the coolant; one of two distal liquid-cooling spaces of the plurality of liquid-cooling spaces in the predetermined direction is in communication with the liquid-inlet pipeline, the other of the two distal liquid-cooling spaces is in communication with the liquid-outlet pipeline, and every two adjacent liquid-cooling spaces of the plurality of liquid-cooling spaces are in communication with each other through the series-flow pipeline. The liquid level adjustment structure is connected to the box body and includes a distribution pipeline in communication with the plurality of liquid-cooling spaces, a fluid control unit, and a plurality of fluid distribution units; the fluid control unit and the plurality of fluid distribution units are arranged on the distribution pipeline, the plurality of fluid distribution units are in one-to-one correspondence to the plurality of liquid-cooling spaces, each fluid distribution unit of the plurality of fluid distribution units is configured to distribute the coolant to a respective liquid-cooling space, and the fluid control unit is configured to control an amount of the coolant distributed by each fluid distribution unit to the respective liquid-cooling space and to adjust a liquid level in the respective liquid-cooling space.

The embodiments of the present disclosure further provide an energy storage system including a plurality of battery modules and the above-mentioned immersion liquid-cooling device. Each battery module of the plurality of battery modules includes a plurality of cells. Each liquid-cooling space of the plurality of liquid-cooling spaces of the box body is configured to accommodate at least one respective battery module of the plurality of battery modules.

The embodiments of the present disclosure further provide a heat management method applied to the above-mentioned immersion liquid-cooling device, including:
injecting the coolant into the plurality of liquid-cooling spaces of the box body through the fluid circulation structure until a liquid level of the coolant reaches an initial liquid level;
detecting temperatures of a plurality of cells of the at least one respective battery module in each liquid-cooling space of the plurality of liquid-cooling spaces;
in response to the temperatures of the plurality of cells going out of a threshold range, rising the liquid level of the coolant in the plurality of liquid-cooling spaces by controlling the plurality of fluid distribution units to distribute using the fluid control unit; and
in response to the temperatures of the plurality of cells not going out of the threshold range, maintaining the liquid level of the coolant in the plurality of liquid-cooling spaces at the initial liquid level.

In the immersion liquid-cooling device, the energy storage system and the heat management method provided in the embodiments of the present disclosure, the plurality of liquid-cooling spaces are formed in the box body, and each liquid-cooling space accommodates respective battery modules. Each liquid-cooling space is connected to the coolant circulation system through the fluid circulation structure, and the coolant can enter the box body through the liquid-inlet pipeline, and continuously circulate among the liquid-cooling spaces through the series-flow pipeline to reach a certain immersion liquid-level height. The coolant takes away the heat of the cells of the battery modules during circulation, thereby realizing sufficient heat dissipation for the battery modules. In addition, the liquid-level heights of the immersion coolant in the liquid-cooling spaces where the battery modules are located can be adjusted individually using the fluid control unit cooperating with the fluid distribution units, so that the heat dissipation capacity of the liquid-cooling spaces where the battery modules are located can be adjusted individually, thereby controlling the temperatures of the battery modules in the energy storage system.

According to the invention, the liquid-inlet pipeline and the liquid-outlet pipeline are arranged on one of two lateral surfaces of the box body extending along a first direction or are arranged on the two lateral surfaces, respectively, and the first direction is perpendicular to an arrangement direction of a plurality of cells of the at least one respective battery module. In this way, the coolant can flow in and be discharged along the arrangement direction of the plurality of cells of the at least one respective battery module, thereby ensuring the heat dissipation effect on the plurality of cells of the at least one respective battery module.

Furthermore according to the invention, the fluid circulation structure includes a plurality of series-flow pipelines, each series-flow pipeline of the plurality of series-flow pipelines is configured to communicate two respective liquid-cooling spaces of the plurality of liquid-cooling spaces that are adjacent in the predetermined direction, and the plurality of series-flow pipelines are alternately arranged on the two lateral surfaces of the box body. In this way, the coolant can flow in a unidirectional and serpentine way through the plurality of liquid-cooling spaces, thereby ensuring that the coolant can sequentially absorb the heat from the battery modules in the plurality of liquid-cooling spaces.

In some embodiments, the fluid circulation structure includes a plurality of liquid-inlet pipelines, a plurality of liquid-outlet pipelines, and a plurality of series-flow pipelines that are arranged at intervals along the first direction, respectively. In this way, the number of pipelines of the fluid circulation structure can be increased, thereby increasing the flow paths of the coolant, and ensuring the stable flow of the coolant.

In some embodiments, the box body includes a frame, walls arranged on the frame and forming an enclosed space, and separators dividing the enclosed space into the plurality of liquid-cooling spaces. The frame has a plurality of platforms in one-to-one correspondence to the plurality of liquid-cooling spaces, each platform of the plurality of platforms has a respective hollow area and is configured to support the at least one respective battery module and separate the at least one respective battery module from a corresponding separator of the separators. In this way, the plurality of platforms having the hollow areas can allow the bottoms of the battery modules to be in contact with the immersion coolant for heat exchange, thereby improving the heat dissipation effect of the coolant.

In some embodiments, the frame includes a plurality of columns abutting on the walls, respectively, a plurality of connecting rod assemblies arranged along the predetermined direction and respectively connecting to the plurality of columns, and intermediate rod assemblies in one-to-one correspondence to the plurality of liquid-cooling spaces. Each intermediate rod assembly of the intermediate rod assemblies is connected to a respective connecting rod assembly of the plurality of connecting rod assemblies and includes a respective plurality of intermediate rods arranged at intervals and configured to support the at least one respective battery module, and an extending direction of the respective plurality of intermediate rods is parallel to an arrangement direction of a plurality of cells of the at least one respective battery module. In this way, by forming the frame with a frame-type structure, the bottoms of the battery modules can be ensured to be in full contact with the coolant for heat exchange, thereby ensuring the heat dissipation capacity for the battery modules and the stable support of the battery modules.

In some embodiments, the frame further includes reinforcing rib assemblies in one-to-one correspondence to the plurality of liquid-cooling spaces, each reinforcing rib assembly of the reinforcing rib assemblies is connected to a respective intermediate rod assembly of the intermediate rod assemblies and includes a respective plurality of reinforcing ribs arranged at intervals, and each reinforcing rib of the respective plurality of reinforcing ribs is flush with or lower than the respective plurality of intermediate rods in the predetermined direction. In this way, the structural strengths of the platforms of the frame can be enhanced using the reinforcing ribs without affecting the arrangement of the battery modules.

In some embodiments, the fluid circulation structure further includes a liquid replenishment pipeline, and the liquid replenishment pipeline and the liquid-inlet pipeline are connected to a same liquid-cooling space of the plurality of liquid-cooling spaces. In this way, the coolant can be replenished using the liquid replenishment pipeline, thereby effectively increasing the total volume of the coolant circulating in the box body, so as to improve the heat dissipation capacity of the coolant.

### BRIEF DESCRIPTION OF THE DRAWINGS

Exemplary illustrations of one or more embodiments are provided by reference to pictures in the corresponding accompanying drawings. These exemplary illustrations do not constitute a limitation on the embodiments. Elements with the same reference numerals in the drawings represent similar elements, and the drawings do not constitute a scale limitation unless otherwise specified.
FIG. 1 is a schematic diagram of a three-dimension structure of an energy storage system provided in some embodiments of the present disclosure.
FIG. 2 is a right view of the structure of the energy storage system provided in some embodiments of the present disclosure.
FIG. 3 is a schematic diagram of an internal structure of the energy storage system provided in some embodiments of the present disclosure.
FIG. 4 is a schematic diagram showing the arrangement of the battery modules in the energy storage system provided in some embodiments of the present disclosure.
FIG. 5 is a schematic diagram of a three-dimension structure of a frame in the energy storage system provided in some embodiments of the present disclosure.
FIG. 6 is a flowchart of a heat management method for an immersion liquid-cooling device in the energy storage system provided in some embodiments of the present disclosure.

### DETAILED DESCRIPTION OF THE EMBODIMENTS

In order to make the object, technical solutions and advantages of the embodiments of the present disclosure clearer, the embodiments of the present disclosure will be illustrated in the following, with reference to the accompanying drawings. Those skilled in the art shall understand that in the embodiments of the present disclosure, many technical details are put forward to make readers better understand the present disclosure. However, even without these technical details and various changes and modifications based on the following embodiments, the technical solutions claimed in the present disclosure can be realized. The following embodiments are illustrated individually for the convenience of description, but do not suggest any limitation on the specific implementation of the present disclosure. The embodiments can be combined with each other and referred to without contradiction.

Unless otherwise defined, all technical and scientific terms used herein have the same meaning as commonly understood by those skilled in the art to which the present disclosure belongs. The terms used herein are for the purpose of describing specific embodiments only and are not intended to limit the present disclosure. The terms "include" and "have" and any variations thereof in the specification and claims of the present disclosure and the above description of the drawings are intended to refer to non-exclusive inclusion.

In the description of the embodiments of the present disclosure, unless otherwise specified and limited, technical terms such as "install", "interconnect" and "connect" should be broadly understood. For example, it may be a fixed connection, a detachable connection or an integrated connection, it may also be a mechanical connection or an electrical connection, it may be a direct connection, or an indirect connection through an intermediate medium, may be the internal connection between two elements or the interaction between two elements. For those skilled in the art, the specific meanings of the above terms in the embodiments of the present disclosure can be understood according to the specific situations.

The effective utilization of energy is inseparable from energy storage systems. An energy storage system can effectively store the electrical energy converted by a power generation system and release the stored electrical energy as required by the power consumption system. With the energy storage systems, the waste of electrical energy generated by the power generation system during off-peak power consumption period can be prevented, and the shortage of power supply in power consumption system during peak power consumption period can be addressed. The battery modules in an energy storage system contain a large number of cells. By connecting the large number of cells in series or in parallel, energy can be stored as much as possible.

Currently, most energy storage systems use liquid-cooling plates for cooling. However, limited by the heat dissipation capacity of liquid-cooling plates, battery modules generally suffer from uneven distribution of temperatures of the internal cells and excessive temperature rise in some cells. These problems greatly reduce the working efficiency of the energy storage systems. Therefore, a new heat dissipation device for the energy storage systems is needed.

In order to individually control the temperatures of the battery modules in the energy storage system, some embodiments of the present disclosure provide an immersion liquid-cooling device. The immersion liquid-cooling device uses immersion liquid cooling in clusters, the battery modules are immersed in the coolant, and the cells of the battery modules can fully contact with the coolant to exchange heat and realize heat dissipation. In addition, the liquid-level heights of the immersion coolant corresponding to the battery modules can be adjusted individually, so that the heat dissipation capacity can be adjusted by individually adjusting the liquid-level heights of the immersion coolant for the battery modules. In this way, the temperatures of the battery modules can be controlled individually.

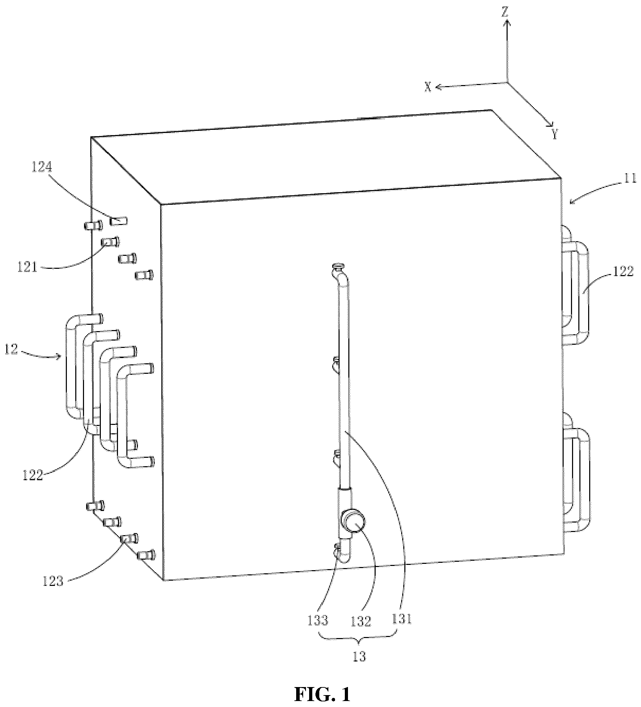

In the following, the structure of the immersion liquid-cooling device in the energy storage system provided in some embodiments of the present disclosure will be described with reference to FIG. 1 to FIG. 5.

As shown in FIG. 1 to FIG. 5, the immersion liquid-cooling device provided in some embodiments of the present disclosure includes a box body 11, a fluid circulation structure 12, and a liquid level adjustment structure 13. The box body 11 has a plurality of liquid-cooling spaces 101 sequentially formed along a predetermined direction (the direction indicated by arrow Z in FIG. 1) and isolated from each other, and each liquid-cooling space 101 is configured to accommodate at least one respective battery module 21. The fluid circulation structure 12 is connected to the box body 11. The fluid circulation structure 12 includes a liquid-inlet pipeline 121, a series-flow pipeline 122 and a liquid-outlet pipeline 123. The liquid-inlet pipeline 121 is configured to supply a coolant, the series-flow pipeline 122 is configured to transfer the coolant, and the liquid-outlet pipeline 123 is configured to discharge the coolant. One of two distal liquid-cooling spaces 101 in the predetermined direction is in communication with the liquid-inlet pipeline 121, and the other distal liquid-cooling space is in communication with the liquid-outlet pipeline 123. Every two adjacent liquid-cooling spaces 101 are in communication with each other through the series-flow pipeline 122. The liquid level adjustment structure 13 is connected to the box body 11. The liquid level adjusting structure 13 includes a distribution pipeline 131 in communication with the plurality of liquid-cooling spaces 101, and further includes a fluid control unit 132 and a plurality of fluid distribution units 133. The fluid control unit 132 and the plurality of fluid distribution units 133 are arranged on the distribution pipeline 131. The plurality of fluid distribution units 133 are in one-to-one correspondence to the plurality of liquid-cooling spaces 101, each fluid distribution unit 133 is configured to distribute the coolant to a respective liquid-cooling space 101, and the fluid control unit 132 is configured to control an amount of the coolant distributed by each fluid distribution unit 133 to the respective liquid-cooling space 101 and to adjust a liquid level in the respective liquid-cooling space 101.

The box body 11 provides an accommodation space for assembling the energy storage system. The battery modules 21 may be fixed at different positions inside the box body 11. In order to achieve immersion liquid cooling for the battery modules 21, the plurality of liquid-cooling spaces 101 are provided inside the box body 11, and each liquid-cooling space 101 is relatively enclosed. After injected into the liquid-cooling spaces 101, the coolant may partially or completely immerse the battery modules 21. In the immersion state by the coolant, the cells 211 of the battery modules 21 can fully contact with the coolant to achieve heat dissipation. Each liquid-cooling space 101 may accommodate one or more battery modules 21. The plurality of liquid-cooling spaces 101 are sequentially formed along the predetermined direction, where the predetermined direction may be a vertical direction, a horizontal direction, or other directions forming an included angle with the vertical direction. In practice, the plurality of liquid-cooling spaces 101 may be formed in layers or separated from each other. The overall shape of the box body 11 may be a regular shape such as a cube, a cuboid, or a cylinder, or the box body 11 may have an irregular special shape. The liquid-cooling spaces 101 inside the box body 11 may have regular shapes such as cubes, cuboids, or cylinders, or may have irregular special shapes.

The fluid circulation structure 12 is configured to facilitate the connection of the coolant circulation system to the internal space of the box body 11. The fluid circulation structure 12 includes a liquid-inlet pipeline 121 for inputting the coolant to the liquid-cooling spaces 101 of the box body 11, a series-flow pipeline 122 for transferring the coolant between two adjacent liquid-cooling spaces 101, and a liquid-outlet pipeline 123 for discharging the coolant. One end of the liquid-inlet pipeline 121 protruding from the box body 11 may be connected to a pipeline for supplying the coolant, and the other end of the liquid-inlet pipeline 121 is in communication with one of the two distal liquid-cooling spaces 101 which are the farthest apart in the predetermined direction. One end of the liquid-outlet pipeline 123 protruding from the box body 11 may be connected to a pipeline for recovering the coolant, and the other end of the liquid-outlet pipeline 123 is in communication with the other one of the two distal liquid-cooling spaces 101 that are the farthest apart in the predetermined direction. Two ends of the series-flow pipeline 122 are in communication with two adjacent liquid-cooling spaces 101. The plurality of liquid-cooling spaces 101 are in communication with each other through the series-flow pipelines 122, so that the circulating coolant can reach each liquid-cooling space 101 of the box body 11. In practice, the plurality of liquid-cooling spaces 101 may be sequentially connected through the series-flow pipelines 122, so that the coolant flows through the plurality of liquid-cooling spaces 101 in sequence. Alternatively, when a large number of liquid-cooling spaces 101 are provided, some liquid-cooling spaces 101 may be in communication with two or more other liquid-cooling spaces 101, so that the coolant can be concurrently distributed to two or more liquid-cooling spaces 101 during circulating. The connection positions of each pipeline of the fluid circulation structure 12 on the box body 11 may be determined according to actual needs. In order to ensure the flow effect of the coolant in each liquid-cooling space 101, the connection positions of each pipeline may be close to the bottom of the corresponding liquid-cooling space 101.

The liquid level adjustment structure 13 is configured to adjust the liquid-level height of the immersion coolant in each liquid-cooling space 101 of the box body 11. The liquid level adjustment structure 13 includes a distribution pipeline 131 in communication with the plurality of liquid-cooling spaces 101. A fluid control unit 132 and fluid distribution units 133 in one-to-one correspondence to the plurality of liquid-cooling spaces 101 are arranged on the distribution pipeline 131. The fluid distribution units 133 can control the flow rate of the coolant flowing through where the fluid distribution units are arranged, and the fluid control unit 132 can control the flow of the coolant. Each of the fluid distribution units 133 may be a solenoid valve, a throttle valve, or a flow control valve with an adjustable opening. The fluid control unit 132 may be a pump, such as a positive-displacement pump, a vane pump, or a centrifugal pump.

When the energy storage system detects that the temperature of the cells 211 of a certain battery module 21 is too high, the liquid level adjustment structure 13 may be used to actively adjust the liquid-level height of the immersion coolant in the liquid-cooling space 101 where the battery module 21 is arranged, so that the liquid-level height of the coolant in the liquid-cooling space 101 where the battery module 21 is arranged is raised. Therefore, the heat dissipation capacity of the liquid-cooling space 101 is improved, and the temperature of the cells 211 of the battery module 21 is controlled to remain within a reasonable range.

In the immersion liquid-cooling device provided in some embodiments of the present disclosure, the plurality of liquid-cooling spaces 101 are formed in the box body 11, and each liquid-cooling space 101 accommodates respective battery modules 21. Each liquid-cooling space 101 is connected to the coolant circulation system through the fluid circulation structure 12, and the coolant can enter the box body 11 through the liquid-inlet pipeline 121, and continuously circulate among the liquid-cooling spaces 101 through the series-flow pipeline 122 to reach a certain immersion liquid-level height. The coolant takes away the heat of the cells 211 of the battery modules 21 during circulation, thereby realizing sufficient heat dissipation for the battery modules 21. In addition, the liquid-level heights of the immersion coolant in the liquid-cooling spaces 101 where the battery modules 21 are located can be adjusted individually using the fluid control unit 132 cooperating with the fluid distribution units 133, so that the heat dissipation capacity of the liquid-cooling spaces 101 where the battery modules 21 are located can be adjusted individually, thereby controlling the temperatures of the battery modules 21 in the energy storage system.

The liquid-inlet pipeline 121 and the liquid-outlet pipeline 123 are arranged on one of two lateral surfaces of the box body extending along a first direction (the direction indicated by the arrow Y in FIG. 1) or are arranged on the two lateral surfaces, respectively. The first direction is perpendicular to an arrangement direction (the direction indicated by the arrow X in FIG. 1) of a plurality of cells 211 of the at least one respective battery module 21.

The liquid-inlet pipeline 121 is configured to control the inflow of the coolant to the liquid-cooling spaces 101 inside the box body 11, and the liquid-outlet pipeline 123 is configured to control the outflow of the coolant from the liquid-cooling spaces 101 inside the box body 11. By arranging the liquid-inlet pipeline 121 and the liquid-outlet pipeline 123 on a same lateral surface of the box body or on the two lateral surfaces, respectively, the flow direction of the coolant during inflow and outflow can be consistent with the arrangement direction of the plurality of cells 211 of the at least one respective battery module 21, so that the coolant can be controlled to flow inside the box body 11 along the arrangement direction of the plurality of cells 211 of the at least one respective battery module 21, thereby ensuring the heat dissipation effect for the cells 211 of the at least one respective battery module 21.

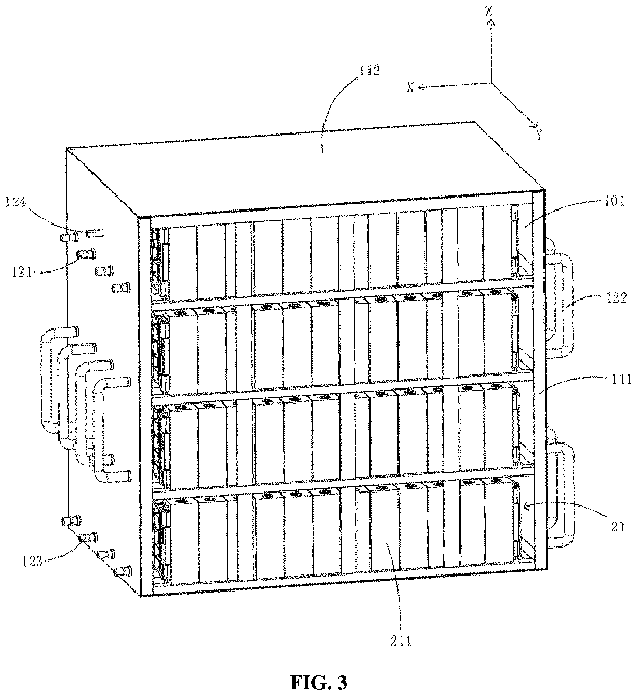

When the number of liquid-cooling spaces 101 is even, the liquid-inlet pipeline 121 and the liquid-outlet pipeline 123 may be arranged on a same lateral surface of the box body 11. When the number of liquid-cooling spaces 101 is odd, the liquid-inlet pipeline 121 and the liquid-outlet pipeline 123 may be arranged on the two lateral surfaces of the box body 11, respectively. As shown in FIG. 3, the box body 11 is provided with four liquid-cooling spaces 101. The liquid-inlet pipeline 121 and the liquid-outlet pipeline 123 are arranged on a same lateral surface of the box body 11, and the end of the liquid-inlet pipeline 121 and the end of the liquid-outlet pipeline 123 that are connected to the liquid-cooling spaces 101 face the two surfaces of the cells 211 of the battery modules 21 having relatively large areas, that is, face the arrangement direction of the plurality of cells 211.

In practice, in order to ensure that the coolant fully contacts with each cell 211 of the battery modules 21 and smoothly flows through each liquid-cooling space 101, an end of the series-flow pipeline 122 that receives the coolant may be arranged on the downstream side of the coolant flowing in each liquid-cooling space 101, and an end of the series-flow pipeline 122 from which the coolant flows out may be arranged on the upstream side of the coolant flowing in each liquid-cooling space 101. Moreover, when the liquid-cooling spaces 101 are arranged in layers, the liquid-inlet pipeline 121 may be arranged at or close to the top of the box body 11, and the liquid-outlet pipeline 123 may be arranged at or close to the bottom of the box body 11, so that the coolant can smoothly flow through the liquid-cooling spaces 101 of the box body 11 under the action of gravity.

According to the invention , the fluid circulation structure includes a plurality of series-flow pipelines 122. Each series-flow pipeline 122 is configured to communicate two respective liquid-cooling spaces 101 that are adjacent in the predetermined direction, and in the predetermined direction, the plurality of series-flow pipelines 122 are alternately arranged on the two lateral surfaces of the box body 11 extending along the first direction.

When more than two liquid-cooling spaces 101 are provided in the box body 11, more than two series-flow pipelines 122 are provided to take the plurality of liquid-cooling spaces 101 into communication with each other. Every two adjacent liquid-cooling spaces 101 are communicated by one series-flow pipeline 122, and in the predetermined direction, the plurality of series-flow pipelines 122 are alternately arranged on the two lateral surfaces of the box body 11. In this way, the plurality of liquid-cooling spaces 101 are connected in an end-to-end way. After injected into the box body 11, the coolant can flow in the box body 11 in a serpentine way, thereby realizing full contact of the coolant with each battery module 21, and effectively taking away the heat from the cells 211 of each battery module 21.

In some embodiments, the fluid circulation structure includes a plurality of liquid-inlet pipelines 121, a plurality of liquid-outlet pipelines 123, and a plurality of series-flow pipelines 122 that are arranged at intervals along the first direction, respectively.

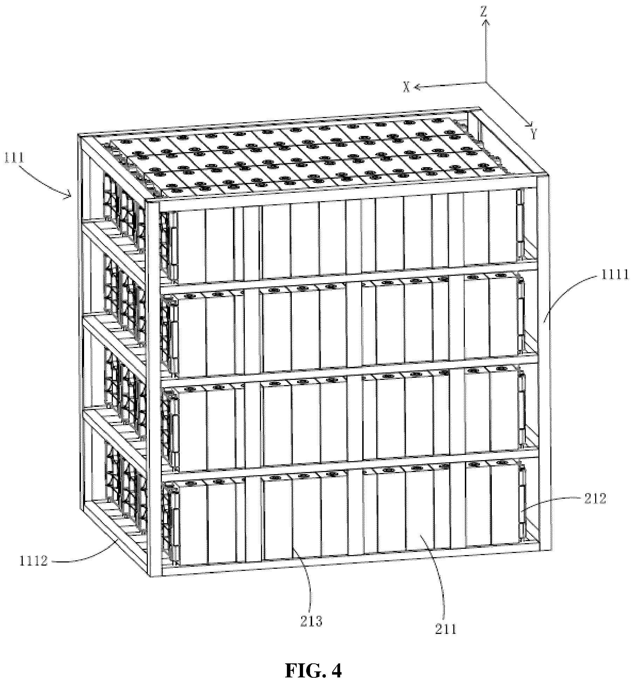

The liquid-cooling spaces 101 inside the box body 11 generally have relatively large volumes to accommodate one or more battery modules 21. The battery modules 21 may be arranged in parallel, sequentially, or in an array in the liquid-cooling spaces 101. In order to adapt to the size of the space inside the box body 11, the number of pipelines of the fluid circulation structure 12 may be increased. Thus, the plurality of liquid-inlet pipelines 121, the plurality of liquid-outlet pipelines 123, and the plurality of series-flow pipelines 122 are provided. Furthermore, the plurality of liquid-inlet pipelines 121, the plurality of liquid-outlet pipelines 123, and the plurality of series-flow pipelines 122 are arranged at intervals along the first direction, respectively. In other words, these pipelines are arranged along an apposition direction of the plurality of battery modules 21. In this way, the coolant flowing in the liquid-cooling spaces 101 can fully immerse the areas where the battery modules 21 are arranged, thereby realizing uniform heat dissipation for each battery module 21 in a same liquid-cooling space 101, and ensuring that a sufficient amount of coolant can continuously flow into the liquid-cooling spaces 101 of the box body 11. In practice, the number of pipelines of the fluid circulation structure 12 may be consistent with the number of the apposed battery modules 21 in each liquid-cooling space 101. For example, each liquid-cooling space 101 of the box body 11 shown in FIG. 3 and FIG. 4 may accommodate four battery modules 21 arranged side-by-side, and the fluid circulation structure 12 may include four corresponding liquid-inlet pipelines 121, four liquid-outlet pipelines 123, and four series-flow pipelines 122 for communicating adjacent liquid-cooling spaces 101. The four battery modules 21 are arranged at intervals, and the coolant may flow along the side surfaces of each battery module 21, so as to take away the heat from each battery module 21.

In addition, when the battery modules 21 are arranged in the liquid-cooling spaces 101 inside the box body 11, a certain space may be reserved under the bottom of each battery module 21, so that the coolant can contact with the bottoms of the battery modules 21 after being injected into the liquid-cooling spaces 101, thereby ensuring the contact area between the coolant and the cells 211 of the battery modules 21 and realizing effective heat transfer. That is, the battery modules 21 may be arranged on platforms 102 having hollow areas.

In some embodiments, the box body 11 may include a frame 111, walls 112 arranged on the frame 111 and forming an enclosed space, and separators 113 dividing the enclosed space into the plurality of liquid-cooling spaces 101. The frame 111 has a plurality of platforms 102 in one-to-one correspondence to the plurality of liquid-cooling spaces 101. Each platform 102 has a respective hollow area and is configured to support the at least one respective battery module 21 and separate the at least one respective battery module 21 from a corresponding separator 113.

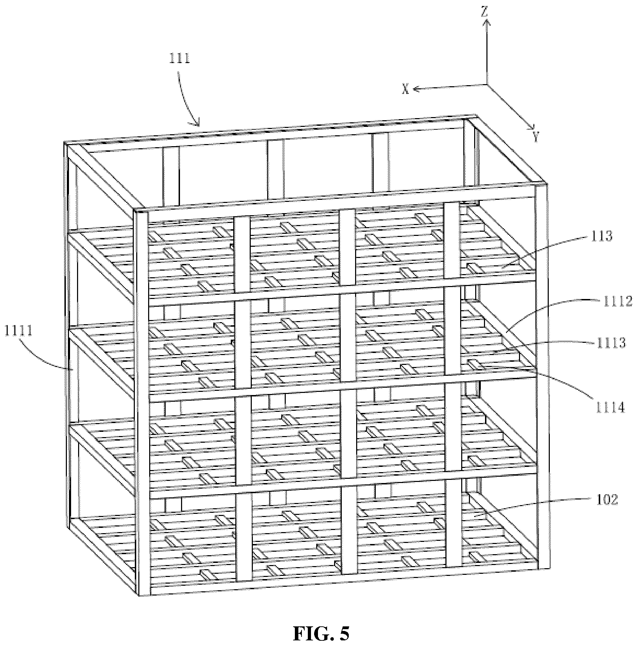

The frame 111 is configured to form platforms 102 for arranging the battery modules 21 in the box body 11. The frame 111 may be a frame-type component and is made by splicing and assembling. In order to ensure the structural strength of the frame 111, the frame 111 may be made of metal. The walls 112 are arranged on an outer contour of the frame 111. The internal accommodation space of the box body 11 may be enclosed by the walls 112, so that the battery modules 21 are arranged in a closed environment relative to the external environment. The separators 113 divides the enclosed space formed by the walls 112 into the plurality of liquid-cooling spaces 101. The separators 113 may be in the form of flat plates and may be connected and fixed to the walls 112 or the frame 111. Each liquid-cooling space 101 is kept in a relatively closed state by the separators 113. As shown in FIG. 5, the separators 113 are arranged on the three intermediate platforms 102 of the frame 111, respectively. The three separators 113 cooperate with the walls 112 to form four relatively closed liquid-cooling spaces 101. The relatively closed liquid-cooling spaces 101 are in communication with each other through the series-flow pipelines 122 to form a complete flow channel for the coolant.

The platforms 102 provided by the frame 111 are in one-to-one correspondence to the liquid-cooling spaces 101, and each platform 102 has a respective hollow area. When the battery modules 21 are fixed on the platforms 102, the bottom of each battery module 21 may be spaced from a corresponding separator 113. In this way, the coolant can enter the hollow areas of the platforms 102 to fully contact with the bottoms of the battery modules 21. Meanwhile, the coolant may also keep in contact with the lateral surfaces of the battery modules 21. As a result, the bottom and the lateral surfaces of each battery module 21 can be in contact with the immersion coolant for heat exchange. In practice, when fixing the battery modules 21, they may be connected to the frame 111 using long bolts. A long bolt may pass through an outermost end plate 212 of a battery module 21 and be fixed on the frame 111, thereby completing the fixation of the battery module 21. There may be a gap between two adjacent cells 211 of a battery module 21 to allow the coolant to be in contact with the peripheries of the cells 211 for heat exchange.

In some embodiments, channels configured for the coolant to flow may be arranged inside the walls 112 of the box body 11, so that the walls 112 enclosing the frame 111 also have heat-absorbing capacity. That is to say, the six walls 112 of the box body 11 shown in FIG. 3 may all be provided with hollow channels. The coolant may be injected into these channels, so that the coolant circulates inside the walls 112 to take away the heat transferred to the walls 112. In order to extend the flow paths of the coolant and ensure sufficient heat absorption by the coolant, each of the channels may have a curved shape. In practice, heat-dissipating components, such as heat pipes, with high efficiency may be provided on the surfaces of the walls or arranged inside the walls 112, so as to conduct the heat transferred from the coolant in the liquid-cooling spaces 101 to the walls 112 to the external environment in time, thereby improving the heat dissipation capacity for the battery modules 21. The heat pipes may be in contact with the walls 112 and the external environment along length directions, or one end of a heat pipe may pass through a wall 112 to contact with the coolant in a liquid-cooling space 101, and the other end contacts with the external environment.

Moreover, each separator may have respective grooves formed on a respective surface of each separator 113 bearing the coolant, and the respective grooves are configured for the coolant to flow. For example, grooves recessed inward may be formed on the surfaces of the separators 113. These grooves may have cross-sectional shapes such as triangles, squares, or rectangles. The coolant may flow along the grooves to reach specific positions in the liquid-cooling spaces 101, which is beneficial to ensuring the flow effect of the coolant at the bottoms of the battery modules 21. Moreover, in order to improve the heat-exchange effect of the coolant, each of the grooves may have a respective curved shape or extend along a respective curved path, thereby prolonging the flow paths of the coolant, and fully absorbing the heat from the battery modules 21.

In addition, as shown in FIG. 4 and FIG. 5, the frame 111 may include a plurality of columns 1111 that abut on the walls 112, respectively, a plurality of connecting rod assemblies 1112 that are arranged along the predetermined direction and respectively connected to the plurality of columns, and intermediate rod assemblies 1113 that are in one-to-one correspondence to the liquid-cooling spaces 101. Each intermediate rod assembly 1113 is connected to a respective connecting rod assembly 1112 and includes a respective plurality of intermediate rods that are arranged at intervals and configured to support the at least one respective battery modules 21. An extending direction of the respective plurality of intermediate rods is parallel to the arrangement direction of the plurality of cells 211 of each battery module 21.

The columns 1111 form the outer contour of the frame 111, and support and abut on the inner surfaces of the walls 112 facing the enclosed space. Each column 1111 extends along the predetermined direction. The plurality of columns 1111 are connected together by the connecting rod assemblies 1112. In the predetermined direction, the connecting rod assemblies 1112 are located at intermediate positions and are located at the tops of the separators 113, respectively. The plurality of connecting rods of each connecting rod assembly 1112 may be connected to each other in an end-to-end way, in order to connect and fix the plurality of columns 1111 along a circumferential direction, thereby ensuring the strength of the formed frame-type structure.

The intermediate rod assemblies 1113 are in one-to-one correspondence to the liquid-cooling spaces 101. Two ends of each intermediate rod of the intermediate rod assemblies 1113 are connected to two respective connecting rods of the connecting rod assemblies 1112, respectively. Moreover, the plurality of intermediate rods of each intermediate rod assembly 1113 are arranged at intervals, and are in contact with only a portion of the surface areas of the battery modules 21 when supporting the battery modules 21. Therefore, relatively large hollow areas are formed below the bottoms of the battery modules 21, thereby facilitating the filling of the coolant at the bottoms of the battery modules 21 as much as possible.

In some embodiments, thermally conductive components may be arranged on the intermediate rod assemblies 1113 of the frame 111. The thermally conductive components are made of thermally conductive materials. The thermally conductive components may have regular shapes, such as cylinders, cubes, or cuboids, or have irregular shapes. The thermally conductive components may have shapes of islands and are arranged on each platform 102, respectively, and the thermally conductive components may pass through a separator 113 and extend into a liquid-cooling space 101 corresponding to another platform 102. In this way, thermal conduction can be achieved between liquid-cooling spaces 101 under the thermally conductive effects of the thermally conductive components, thereby ensuring the heat dissipation balance of the coolant in different liquid-cooling spaces 101.

As shown in FIG. 5, the frame 111 may further include reinforcing rib assemblies 1114 in one-to-one correspondence to the liquid-cooling spaces 101. Each reinforcing rib assembly 1114 is connected to a respective intermediate rod assembly 1113 and includes a respective plurality of reinforcing ribs arranged at intervals, and each reinforcing rib is flush with or lower than the respective plurality of intermediate rods in the predetermined direction.

The reinforcing rib assemblies 1114 can strengthen the structural strength of each platform 102 of the frame 111, thereby improving the capacity of each platform 102 of supporting the battery modules 21. Each reinforcing rib of the reinforcing rib assemblies 1114 may connect two respective adjacent intermediate rods of the intermediate rod assemblies 1113 to each other, so that the plurality of intermediate rods of each intermediate rod assembly 1113 are connected into a whole. An extending direction of the reinforcing ribs may be perpendicular to the extending direction of the intermediate rods.

Each reinforcing rib is flush with or lower than the respective plurality of intermediate rods, without affecting the fixation of the battery modules 21 on the platforms 102. Moreover, when the structural strengths of the reinforcing ribs are sufficient, gaps may be left between the reinforcing ribs and the battery modules 21, thereby facilitating the immersion coolant to contact with the bottoms of the battery modules 21 and achieve heat exchange.

In addition, each reinforcing rib assembly 1114 may include first reinforcing ribs and second reinforcing ribs having different extension directions. In this way, the structural strength of each platform 102 can be improved in different directions. In practice, the first reinforcing ribs and the second reinforcing ribs may be separated from each other, or may be connected together to form a whole. Furthermore, a respective distance between every two reinforcing ribs of the respective plurality of reinforcing ribs may be adjusted, so as to adapt to the filling amount of the coolant in different areas within a same liquid-cooling space 101, thereby optimizing the heat dissipation capacity in different areas within a same liquid-cooling space 101. For example, in the downstream areas for the coolant flowing in a liquid-cooling space 101, the number of arranged reinforcing ribs may be reduced to provide a larger filling space for the coolant, so that a sufficient amount of coolant can be filled under the bottoms of the battery modules 21, thereby ensuring the heat dissipation capacity of the coolant in the terminal segment of the flow path.

In some embodiments, as shown in FIG. 1, the fluid circulation structure 12 may further include a liquid replenishment pipeline 124, and the liquid replenishment pipeline 124 and the liquid-inlet pipeline 121 are connected to a same liquid-cooling space of the plurality of liquid-cooling spaces 101.

The liquid replenishment pipeline 124 may also be connected to the pipelines for supplying the coolant in the coolant circulation system, thereby injecting the coolant into the liquid-cooling spaces 101. The liquid replenishment pipeline 124 provides an independent channel for the coolant to enter the liquid-cooling spaces 101 in the box body 11. The coolant may be replenished into the liquid-cooling spaces 101 through the liquid replenishment pipeline 124, thereby increasing the amount of the coolant entering the liquid-cooling spaces 101. For example, when the temperatures of the cells 211 of the battery modules 21 accommodated in the box body 11 go out of the threshold range to a certain value, the coolant may be replenished through the liquid replenishment pipeline 124. Thus, in addition to the total capacity of the coolant currently flowing in the box body 11, a certain volume of the coolant is injected to improve the heat dissipation capacity. In addition, the flow rate of the coolant can be increased by increasing the fluid circulation rate, so as to take away the excessive heat in time.

As shown in FIG. 1, the distribution pipeline 131 and the series-flow pipelines 122 may be arranged on different lateral surfaces of the box body 11, respectively.

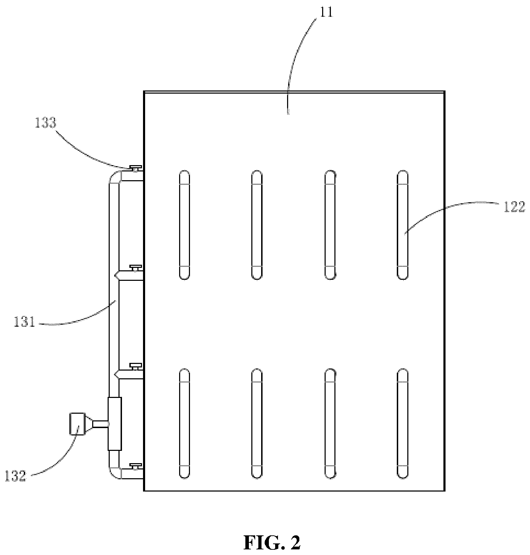

In this way, the mutual interference between the fluid circulation structure 12 and the liquid level adjustment structure 13 can be reduced, thereby preventing the fluctuations of liquid levels in the liquid-cooling spaces 101. As shown in FIG. 1 and FIG. 2, the distribution pipeline 131 is connected to a lateral surface of the box body 11 having a relatively large area. The distribution pipeline includes a main pipeline and a plurality of branch pipelines. The main pipeline is arranged along the predetermined direction. One respective end of each branch pipeline of the plurality of branch pipelines is in communication with the main pipeline, and the other respective end of each branch pipeline is in communication with a corresponding liquid-cooling space 101. Each fluid distribution unit 133 is arranged on a respective branch pipeline. The fluid control unit 132 is arranged on the main pipeline. The series-flow pipelines 122 are connected to the lateral surfaces of the box body 11 having relatively large areas. In practice, the distribution pipeline 131 may be arranged to space apart from the series-flow pipelines 122, so as to ensure the precise adjustment of liquid-level heights.

Some embodiments of the present disclosure provide an energy storage system including a plurality of battery modules 21 and the immersion liquid-cooling device as illustrated above. Each battery module 21 includes a plurality of cells 211 arranged sequentially, and each liquid-cooling space 101 of the box body 11 of the immersion liquid-cooling device accommodates at least one respective battery module 21.

The plurality of battery modules 21 are fixed inside the box body 11. Each liquid-cooling space 101 of the box body 11 may accommodate at least one respective battery module 21. The temperatures of the plurality of cells 211 of the at least one respective battery module 21 may be monitored by arranging thermocouples at pole pillars, and the temperatures of the plurality of cells 211 may be controlled using the immersion coolant. The immersion coolant may fully contact with the cells 211 to exchange heat, and take away the heat generated during the operation of the cells 211 in time, so as to realize effective heat dissipation of the battery modules 21.

In addition, as shown in FIG. 4, a heat-insulating material 213 may be provided between every two adjacent cells 211 of the battery modules 21.

The heat-insulating material 213 may be filled between every two adjacent cells 211, so as to prevent mutual influence due to mutual contact between the two adjacent cells 211, and prevent the thermal conduction between every two adjacent cells 211, thereby preventing the temperature control of the cells 211 from being affected.

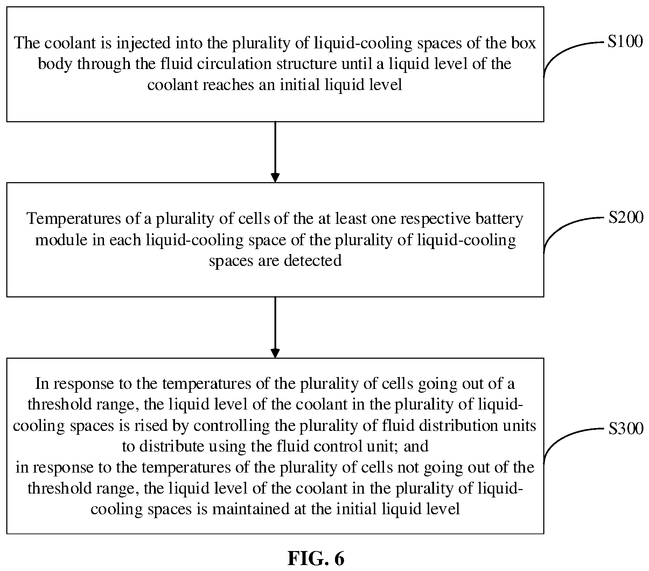

As shown in FIG. 6, some embodiments of the present disclosure provide a heat management method applied to the immersion liquid-cooling device as illustrated above.

At S100, the coolant is injected into the plurality of liquid-cooling spaces 101 of the box body 11 through the fluid circulation structure 12 until a liquid level of the coolant reaches an initial liquid level.

The initial liquid level may be set at 50% of the maximum height in the liquid-cooling spaces 101, that is, the liquid-cooling spaces 101 are semi-immersed, so as to adjust the liquid-level heights of the coolant based on the temperatures of the cells 211 later.

At S200, temperatures of the plurality of cells 211 of the at least one respective battery module 21 in each liquid-cooling space 101 is detected.

The temperatures of the cells 211 may be detected using temperature monitoring elements on the cells 211. For example, a thermocouple may be arranged on a pole pillar of a cell 211 to obtain the temperature information of this cell 211, so as to facilitate subsequent liquid-level adjustment.

At S300, in response to the temperatures of the plurality of cells 211 going out of a threshold range, rising the liquid level of the coolant in the plurality of liquid-cooling spaces 101 by controlling the plurality of fluid distribution units 133 to distribute using the fluid control unit 132; and in response to the temperatures of the plurality of cells 211 not going out of the threshold range, maintaining the liquid level of the coolant in the plurality of liquid-cooling spaces 101 at the initial liquid level.

That is to say, when the temperatures of the plurality of cells 211 go out of a threshold range, the liquid-level height of the immersion coolant in the liquid-cooling space 101 where the battery module 21 is located may be increased, thereby improving the heat dissipation capacity within the liquid-cooling space 101 and taking away the heat from the cells 211 in time. When the temperatures of the plurality of cells 211 do not go out of the threshold range, i.e. within a reasonable range, the coolant in the liquid-cooling space 101 is maintained at the initial liquid level.

In practice, taking the immersion liquid-cooling device in the energy storage system shown in FIG. 1 as an example, each liquid-cooling space 101 inside the box body 11 is semi-immersed by the immersion coolant, that is, 50% of the maximum height of each liquid-cooling space 101 is immersed. After the battery modules 21 start to charge and discharge, the coolant is injected into the box body 11 from the liquid-inlet pipeline 121, and realizes the unidirectional flow and heat exchange in the liquid-cooling spaces 101 through the series-flow pipelines 122. Since the heat dissipation capacity of the coolant gradually decreases as it continuously absorbs heat during flowing, the following control strategy may be implemented based on the temperature monitoring data of the cells 211:
(1) When the maximum temperature difference between the cells 211 of two battery modules 21 in the box body 11 is less than 2°C (degrees Celsius), the fluid control unit 132 and the plurality of fluid distribution units 133 of the liquid level adjustment structure 13 do not perform fluid distribution, and the immersion heights of the coolant in the plurality of liquid-cooling spaces 101 remain unchanged.
(2) When the maximum temperature difference between the cells 211 of two battery modules 21 in the box body 11 is greater than 2°C and less than 3°C, the fluid control unit 132 and the plurality of fluid distribution units 133 of the liquid level adjustment structure 13 are activated, and openings of the plurality of fluid distribution units 133 are adjusted, so that the liquid-level height of the coolant in a first-layer liquid-cooling space 101 (the liquid-cooling space at the top layer) is reduced by 15%, the liquid-level height of the coolant in a second-layer liquid-cooling space 101 remains unchanged, and the liquid-level heights of the coolant in a third-layer liquid-cooling space 101 and a fourth-layer liquid-cooling space 101 are increased by 5% and 10%, respectively.
(3) When the maximum temperature difference between the cells 211 of two battery modules 21 in the box body 11 is greater than 3°C, the fluid control unit 132 and the plurality of fluid distribution units 133 of the liquid level adjustment structure 13 are activated., and openings of the plurality of fluid distribution units 133 are adjusted, so that the liquid-level height of the coolant in the first-layer liquid-cooling space 101 (the liquid-cooling space at the top layer) is reduced by 30%, the liquid-level height of the coolant in a second-layer liquid-cooling space 101 remains unchanged, and the liquid-level heights of the coolant in a third-layer liquid-cooling space 101 and a fourth-layer liquid-cooling space 101 are increased by 10% and 20%, respectively.
(4) When the maximum temperature difference between the cells 211 of two battery modules 21 in the box body 11 exceeds 10°C, the coolant is replenished through the liquid replenishment pipeline 124. Besides the total capacity of the coolant currently flowing in the box body 11, additional coolant is injected by 10%, and the supply flow rate of the coolant at the liquid-inlet pipeline 121 is increased accordingly.

It is be noted that the above-mentioned control strategy is only an example of the actual control situation. When the temperatures of the cells 211 of the battery modules 21 in a certain liquid-cooling space 101 are abnormal, the liquid-level height or the flow rate of the immersion coolant in this liquid-cooling space 101 may be controlled individually, to improve the heat dissipation capacity of the coolant in this liquid-cooling space 101. For example, in order to control the flow rate of the coolant in each liquid-cooling space 101, a flow control valve may be provided in each pipeline of the fluid circulation structure 12. That is, flow control valves may be provided in the liquid-inlet pipelines 121, the series-flow pipelines 122, or the liquid-outlet pipelines 123, respectively, so as to realize precise control when it is necessary to adjust the flow rate of the coolant in some liquid-cooling spaces 101 individually.

## Claims

1. An immersion liquid-cooling device for an energy storage system, the immersion liquid-cooling device comprising:
a box body (11) having a plurality of liquid-cooling spaces (101) sequentially formed along a predetermined direction and isolated from each other, wherein each liquid-cooling space of the plurality of liquid-cooling spaces (101) is configured to accommodate at least one respective battery module (21);
a fluid circulation structure (12) connected to the box body (11), wherein the fluid circulation structure (12) includes a liquid-inlet pipeline (121) for supplying a coolant, a series-flow pipeline (122) for transferring the coolant, and a liquid-outlet pipeline (123) for discharging the coolant, wherein one of two distal liquid-cooling spaces (101) of the plurality of liquid-cooling spaces (101) in the predetermined direction is in communication with the liquid-inlet pipeline (121), the other of the two distal liquid-cooling spaces (101) is in communication with the liquid-outlet pipeline (123), and every two adjacent liquid-cooling spaces of the plurality of liquid-cooling spaces (101) are in communication with each other through the series-flow pipeline (122); and
a liquid level adjustment structure (13) connected to the box body (11), wherein the liquid level adjustment structure (13) includes a distribution pipeline (131) in communication with the plurality of liquid-cooling spaces (101), a fluid control unit (132), and a plurality of fluid distribution units (133), and wherein the fluid control unit (132) and the plurality of fluid distribution units (133) are arranged on the distribution pipeline (131), the plurality of fluid distribution units (133) are in one-to-one correspondence to the plurality of liquid-cooling spaces (101), each fluid distribution unit of the plurality of fluid distribution units (133) is configured to distribute the coolant to a respective liquid-cooling space (101), and the fluid control unit (132) is configured to control an amount of the coolant distributed by each fluid distribution unit (133) to the respective liquid-cooling space (101) and to adjust a liquid level in the respective liquid-cooling space(101), **characterized in that**
the liquid-inlet pipeline (121) and the liquid-outlet pipeline (123) are arranged on one of two lateral surfaces of the box body (11) extending along a first direction or are arranged on the two lateral surfaces, respectively, and the first direction is perpendicular to an arrangement direction of a plurality of cells (211) of the at least one respective battery module (21); and **in that**
the fluid circulation structure (12) includes a plurality of series-flow pipelines (122), each series-flow pipeline of the plurality of series-flow pipelines (122) is configured to communicate two respective liquid-cooling spaces of the plurality of liquid-cooling spaces (101) that are adjacent in the predetermined direction, and the plurality of series-flow pipelines (122) are alternately arranged on the two lateral surfaces of the box body (11).

2. The immersion liquid-cooling device according to claim 1, **characterized in that** the fluid circulation structure (12) includes a plurality of liquid-inlet pipelines (121), a plurality of liquid-outlet pipelines (123), and a plurality of series-flow pipelines (122) that are arranged at intervals along the first direction, respectively.

3. The immersion liquid-cooling device according to claim 1, **characterized in that** the box body (11) includes a frame (111), walls (112) arranged on the frame (111) and forming an enclosed space , and separators (113) dividing the enclosed space into the plurality of liquid-cooling spaces (101), and wherein the frame (111) has a plurality of platforms (102) in one-to-one correspondence to the plurality of liquid-cooling spaces (101), each platform of the plurality of platforms (102) has a respective hollow area and is configured to support the at least one respective battery module (21) and separate the at least one respective battery module (21) from a corresponding separator of the separators (113).

4. The immersion liquid-cooling device according to claim 3, **characterized in that** the frame (111) includes a plurality of columns (1111) abutting on the walls (112), respectively, a plurality of connecting rod assemblies (1112) arranged along the predetermined direction and respectively connected to the plurality of columns (1111), and intermediate rod assemblies (1113) in one-to-one correspondence to the plurality of liquid-cooling spaces (101); and
wherein each intermediate rod assembly of the intermediate rod assemblies (1113) is connected to a respective connecting rod assembly of the plurality of connecting rod assemblies (1112) and includes a respective plurality of intermediate rods arranged at intervals and configured to support the at least one respective battery module (21), and an extending direction of the respective plurality of intermediate rods is parallel to an arrangement direction of a plurality of cells (211) of the at least one respective battery module (21).

5. The immersion liquid-cooling device according to claim 4, **characterized in that** the frame (111) further includes reinforcing rib assemblies (1114) in one-to-one correspondence to the plurality of liquid-cooling spaces (101), wherein each reinforcing rib assembly of the reinforcing rib assemblies (1114) is connected to a respective intermediate rod assembly of the intermediate rod assemblies (1113) and includes a respective plurality of reinforcing ribs arranged at intervals, and each reinforcing rib of the respective plurality of reinforcing ribs is flush with or lower than the respective plurality of intermediate rods in the predetermined direction.

6. The immersion liquid-cooling device according to any one of claims 3 to 5, **characterized by** further including channels arranged inside the walls (112), wherein the channels are configured for the coolant to flow, and each of the channels has a respective curved shape.

7. The immersion liquid-cooling device according to any one of claims 3 to 6, **characterized by** further including heat-dissipating components arranged on surfaces of the walls (112) or arranged inside the walls (112).

8. The immersion liquid-cooling device according to any one of claims 3 to 7, **characterized in that** each separator of the separators (113) has respective grooves formed on a respective surface of each separator (113) bearing the coolant, and the respective grooves are configured for the coolant to flow; and
wherein each groove of the respective grooves has a respective curved shape or extends along a respective curved path.

9. The immersion liquid-cooling device according to claim 5, **characterized in that** each reinforcing rib assembly of the reinforcing rib assemblies (1114) includes respective first reinforcing ribs and respective second reinforcing ribs, and the respective first reinforcing ribs have an extension direction different from an extension direction of the respective second reinforcing ribs.

10. The immersion liquid-cooling device according to claim 1, **characterized in that** the fluid circulation structure (12) further includes a liquid replenishment pipeline (124), and the liquid replenishment pipeline (124) and the liquid-inlet pipeline (121) are connected to a same liquid-cooling space of the plurality of liquid-cooling spaces (101).

11. The immersion liquid-cooling device according to any one of claims 1 to 10, **characterized in that** each fluid distribution unit of the plurality of fluid distribution units (133) is a solenoid valve, a throttle valve, or a flow control valve with an adjustable opening, and the fluid control unit (132) is a pump.

12. An energy storage system comprising:
a plurality of battery modules (21), wherein each battery module of the plurality of battery modules (21) includes a respective plurality of cells (211); and **characterized by**:
the immersion liquid-cooling device according to any one of claims 1 to 11, wherein each liquid-cooling space of the plurality of liquid-cooling spaces (101) of the box body (11) is configured to accommodate the at least one respective battery module of the plurality of battery modules (21).

13. A heat management method, applied to the immersion liquid-cooling device according to any one of claims 1 to 11, comprising:
injecting (S100) the coolant into the plurality of liquid-cooling spaces (101) of the box body (11) through the fluid circulation structure (12) until a liquid level of the coolant reaches an initial liquid level;
detecting (S200) temperatures of a plurality of cells (211) of the at least one respective battery module (21) in each liquid-cooling space of the plurality of liquid-cooling spaces (101);
in response to the temperatures of the plurality of cells (211) going out of a threshold range, rising (S300) the liquid level of the coolant in the plurality of liquid-cooling spaces (101) by controlling the plurality of fluid distribution units (133) to distribute using the fluid control unit (132); and
in response to the temperatures of the plurality of cells (211) not going out of the threshold range, maintaining (S300) the liquid level of the coolant in the plurality of liquid-cooling spaces (101) at the initial liquid level.

## Patentansprüche

1. Immersionsflüssigkeitskühlvorrichtung für ein Energiespeichersystem, wobei die Immersionsflüssigkeitskühlvorrichtung Folgendes umfasst:
einen Kastenkörper (11) mit einer Vielzahl von Flüssigkeitskühlräumen (101), die entlang einer vorbestimmten Richtung nacheinander ausgebildet und voneinander isoliert sind, wobei jeder Flüssigkeitskühlraum der Vielzahl von Flüssigkeitskühlräumen (101) dazu ausgelegt ist, mindestens ein jeweiliges Batteriemodul (21) aufzunehmen;
eine Fluidzirkulationsstruktur (12), die mit dem Kastenkörper (11) verbunden ist, wobei die Fluidzirkulationsstruktur (12) eine Flüssigkeitseinlassleitung (121) zum Zuführen eines Kühlmittels, eine Reihenströmungsleitung (122) zum Übertragen des Kühlmittels und eine Flüssigkeitsauslassleitung (123) zum Abführen des Kühlmittels beinhaltet, wobei einer von zwei distalen Flüssigkeitskühlräumen (101) der Vielzahl von Flüssigkeitskühlräumen (101) in der vorbestimmten Richtung mit der Flüssigkeitseinlassleitung (121) in Verbindung steht, der andere der zwei distalen Flüssigkeitskühlräume (101) mit der Flüssigkeitsauslassleitung (123) in Verbindung steht und jeweils zwei benachbarte Flüssigkeitskühlräume der Vielzahl von Flüssigkeitskühlräumen (101) über die Reihenströmungsleitung (122) miteinander in Verbindung stehen; und
eine Flüssigkeitsstandeinstellstruktur (13), die mit dem Kastenkörper (11) verbunden ist, wobei die Flüssigkeitsstandeinstellstruktur (13) eine Verteilungsleitung (131), die mit der Vielzahl von Flüssigkeitskühlräumen (101) in Verbindung steht, eine Fluidsteuereinheit (132) und eine Vielzahl von Fluidverteilungseinheiten (133) beinhaltet, und wobei die Fluidsteuereinheit (132) und die Vielzahl von Fluidverteilungseinheiten (133) an der Verteilungsleitung (131) angeordnet sind, die Vielzahl von Fluidverteilungseinheiten (133) in Eins-zu-eins-Entsprechung zu der Vielzahl von Flüssigkeitskühlräumen (101) stehen, jede Fluidverteilungseinheit der Vielzahl von Fluidverteilungseinheiten (133) dazu ausgelegt ist, das Kühlmittel an einen jeweiligen Flüssigkeitskühlraum (101) zu verteilen, und die Fluidsteuereinheit (132) dazu ausgelegt ist, eine Menge des von jeder Fluidverteilungseinheit (133) an den jeweiligen Flüssigkeitskühlraum (101) verteilten Kühlmittels zu steuern und einen Flüssigkeitsstand in dem jeweiligen Flüssigkeitskühlraum (101) einzustellen, **dadurch gekennzeichnet, dass**
die Flüssigkeitseinlassleitung (121) und die Flüssigkeitsauslassleitung (123) an einer von zwei sich entlang einer ersten Richtung erstreckenden Seitenflächen des Kastenkörpers (11) angeordnet sind oder jeweils an den zwei Seitenflächen angeordnet sind, und die erste Richtung senkrecht zu einer Anordnungsrichtung einer Vielzahl von Zellen (211) des mindestens einen jeweiligen Batteriemoduls (21) ist; und
dadurch, dass
die Fluidzirkulationsstruktur (12) eine Vielzahl von Reihenströmungsleitungen (122) beinhaltet, jede Reihenströmungsleitung der Vielzahl von Reihenströmungsleitungen (122) dazu ausgelegt ist, zwei jeweilige Flüssigkeitskühlräume der Vielzahl von Flüssigkeitskühlräumen (101), die in der vorbestimmten Richtung benachbart sind, in Verbindung zu bringen, und die Vielzahl von Reihenströmungsleitungen (122) abwechselnd an den zwei Seitenflächen des Kastenkörpers (11) angeordnet sind.

2. Immersionsflüssigkeitskühlvorrichtung nach Anspruch 1, **dadurch gekennzeichnet, dass** die Fluidzirkulationsstruktur (12) eine Vielzahl von Flüssigkeitseinlassleitungen (121), eine Vielzahl von Flüssigkeitsauslassleitungen (123) und eine Vielzahl von Reihenströmungsleitungen (122) beinhaltet, die jeweils in Abständen entlang der ersten Richtung angeordnet sind.

3. Immersionsflüssigkeitskühlvorrichtung nach Anspruch 1, **dadurch gekennzeichnet, dass** der Kastenkörper (11) einen Rahmen (111), Wände (112), die an dem Rahmen (111) angeordnet sind und einen geschlossenen Raum bilden, und Trennelemente (113) beinhaltet, die den geschlossenen Raum in die Vielzahl von Flüssigkeitskühlräumen (101) unterteilen, und wobei der Rahmen (111) eine Vielzahl von Plattformen (102) in Eins-zu-eins-Entsprechung zu der Vielzahl von Flüssigkeitskühlräumen (101) aufweist, jede Plattform der Vielzahl von Plattformen (102) einen jeweiligen hohlen Bereich aufweist und dazu ausgelegt ist, das mindestens eine jeweilige Batteriemodul (21) zu tragen und das mindestens eine jeweilige Batteriemodul (21) von einem entsprechenden Trennelement der Trennelemente (113) zu trennen.

4. Immersionsflüssigkeitskühlvorrichtung nach Anspruch 3, **dadurch gekennzeichnet, dass** der Rahmen (111) eine Vielzahl von Säulen (1111), die jeweils an den Wänden (112) anliegen, eine Vielzahl von Verbindungsstangenanordnungen (1112), die entlang der vorbestimmten Richtung angeordnet und jeweils mit der Vielzahl von Säulen (1111) verbunden sind, und Zwischenstangenanordnungen (1113) in Eins-zu-eins-Entsprechung zu der Vielzahl von Flüssigkeitskühlräumen (101) beinhaltet; und
wobei jede Zwischenstangenanordnung der Zwischenstangenanordnungen (1113) mit einer jeweiligen Verbindungsstangenanordnung der Vielzahl von Verbindungsstangenanordnungen (1112) verbunden ist und eine jeweilige Vielzahl von Zwischenstangen beinhaltet, die in Abständen angeordnet und dazu ausgelegt sind, das mindestens eine jeweilige Batteriemodul (21) zu tragen, und eine Erstreckungsrichtung der jeweiligen Vielzahl von Zwischenstangen parallel zu einer Anordnungsrichtung einer Vielzahl von Zellen (211) des mindestens einen jeweiligen Batteriemoduls (21) ist.

5. Immersionsflüssigkeitskühlvorrichtung nach Anspruch 4, **dadurch gekennzeichnet, dass** der Rahmen (111) ferner Verstärkungsrippenanordnungen (1114) in Eins-zu-eins-Entsprechung zu der Vielzahl von Flüssigkeitskühlräumen (101) beinhaltet, wobei jede Verstärkungsrippenanordnung der Verstärkungsrippenanordnungen (1114) mit einer jeweiligen Zwischenstangenanordnung der Zwischenstangenanordnungen (1113) verbunden ist und eine jeweilige Vielzahl von Verstärkungsrippen beinhaltet, die in Abständen angeordnet sind, und jede Verstärkungsrippe der jeweiligen Vielzahl von Verstärkungsrippen in der vorbestimmten Richtung bündig mit oder niedriger als die jeweilige Vielzahl von Zwischenstangen ist.

6. Immersionsflüssigkeitskühlvorrichtung nach einem der Ansprüche 3 bis 5, **dadurch gekennzeichnet, dass** sie ferner Kanäle beinhaltet, die im Inneren der Wände (112) angeordnet sind, wobei die Kanäle dazu ausgelegt sind, dass das Kühlmittel strömt, und jeder der Kanäle eine jeweilige gekrümmte Form aufweist.

7. Immersionsflüssigkeitskühlvorrichtung nach einem der Ansprüche 3 bis 6, **dadurch gekennzeichnet, dass** sie ferner Wärmeableitungskomponenten beinhaltet, die an Oberflächen der Wände (112) angeordnet oder im Inneren der Wände (112) angeordnet sind.

8. Immersionsflüssigkeitskühlvorrichtung nach einem der Ansprüche 3 bis 7, **dadurch gekennzeichnet, dass** jedes Trennelement der Trennelemente (113) jeweilige Nuten aufweist, die an einer jeweiligen, das Kühlmittel tragenden Oberfläche jedes Trennelements (113) ausgebildet sind, und die jeweiligen Nuten dazu ausgelegt sind, dass das Kühlmittel strömt; und
wobei jede Nut der jeweiligen Nuten eine jeweilige gekrümmte Form aufweist oder sich entlang eines jeweiligen gekrümmten Pfades erstreckt.

9. Immersionsflüssigkeitskühlvorrichtung nach Anspruch 5, **dadurch gekennzeichnet, dass** jede Verstärkungsrippenanordnung der Verstärkungsrippenanordnungen (1114) jeweilige erste Verstärkungsrippen und jeweilige zweite Verstärkungsrippen beinhaltet, und die jeweiligen ersten Verstärkungsrippen eine Erstreckungsrichtung aufweisen, die sich von einer Erstreckungsrichtung der jeweiligen zweiten Verstärkungsrippen unterscheidet.

10. Immersionsflüssigkeitskühlvorrichtung nach Anspruch 1, **dadurch gekennzeichnet, dass** die Fluidzirkulationsstruktur (12) ferner eine Flüssigkeitsnachfüllleitung (124) beinhaltet, und die Flüssigkeitsnachfüllleitung (124) und die Flüssigkeitseinlassleitung (121) mit einem selben Flüssigkeitskühlraum der Vielzahl von Flüssigkeitskühlräumen (101) verbunden sind.

11. Immersionsflüssigkeitskühlvorrichtung nach einem der Ansprüche 1 bis 10, **dadurch gekennzeichnet, dass** jede Fluidverteilungseinheit der Vielzahl von Fluidverteilungseinheiten (133) ein Magnetventil, ein Drosselventil oder ein Durchflussregelventil mit einstellbarer Öffnung ist, und die Fluidsteuereinheit (132) eine Pumpe ist.

12. Energiespeichersystem, umfassend:
eine Vielzahl von Batteriemodulen (21), wobei jedes Batteriemodul der Vielzahl von Batteriemodulen (21) eine jeweilige Vielzahl von Zellen (211) beinhaltet; und **gekennzeichnet durch**:
die Immersionsflüssigkeitskühlvorrichtung nach einem der Ansprüche 1 bis 11, wobei jeder Flüssigkeitskühlraum der Vielzahl von Flüssigkeitskühlräumen (101) des Kastenkörpers (11) dazu ausgelegt ist, das mindestens eine jeweilige Batteriemodul der Vielzahl von Batteriemodulen (21) aufzunehmen.

13. Wärmemanagementverfahren, angewendet auf die Immersionsflüssigkeitskühlvorrichtung nach einem der Ansprüche 1 bis 11, umfassend:
Einspritzen (S100) des Kühlmittels in die Vielzahl von Flüssigkeitskühlräumen (101) des Kastenkörpers (11) über die Fluidzirkulationsstruktur (12), bis ein Flüssigkeitsstand des Kühlmittels einen anfänglichen Flüssigkeitsstand erreicht;
Erfassen (S200) von Temperaturen einer Vielzahl von Zellen (211) des mindestens einen jeweiligen Batteriemoduls (21) in jedem Flüssigkeitskühlraum der Vielzahl von Flüssigkeitskühlräumen (101);
als Reaktion darauf, dass die Temperaturen der Vielzahl von Zellen (211) einen Schwellenbereich verlassen, Anheben (S300) des Flüssigkeitsstands des Kühlmittels in der Vielzahl von Flüssigkeitskühlräumen (101) durch Steuern der Vielzahl von Fluidverteilungseinheiten (133) zum Verteilen unter Verwendung der Fluidsteuereinheit (132); und
als Reaktion darauf, dass die Temperaturen der Vielzahl von Zellen (211) den Schwellenbereich nicht verlassen, Halten (S300) des Flüssigkeitsstands des Kühlmittels in der Vielzahl von Flüssigkeitskühlräumen (101) auf dem anfänglichen Flüssigkeitsstand.

## Revendications

1. Dispositif de refroidissement liquide par immersion pour un système de stockage d'énergie, le dispositif de refroidissement liquide par immersion comprenant :
un corps de boîtier (11) ayant une pluralité d'espaces de refroidissement liquide (101) formés séquentiellement le long d'une direction prédéterminée et isolés les uns des autres, dans lequel chaque espace de refroidissement liquide de la pluralité d'espaces de refroidissement liquide (101) est configuré pour recevoir au moins un module de batterie (21) respectif ;
une structure de circulation de fluide (12) reliée au corps de boîtier (11), dans lequel la structure de circulation de fluide (12) comprend une canalisation d'entrée de liquide (121) pour fournir un fluide de refroidissement, une canalisation d'écoulement en série (122) pour transférer le fluide de refroidissement, et une canalisation de sortie de liquide (123) pour évacuer le fluide de refroidissement, dans lequel l'un de deux espaces de refroidissement liquide (101) distaux de la pluralité d'espaces de refroidissement liquide (101) dans la direction prédéterminée est en communication avec la canalisation d'entrée de liquide (121), l'autre des deux espaces de refroidissement liquide (101) distaux est en communication avec la canalisation de sortie de liquide (123), et tous deux espaces de refroidissement liquide adjacents de la pluralité d'espaces de refroidissement liquide (101) sont en communication l'un avec l'autre par l'intermédiaire de la canalisation d'écoulement en série (122) ; et
une structure de réglage du niveau de liquide (13) reliée au corps de boîtier (11), dans lequel la structure de réglage du niveau de liquide (13) comprend une canalisation de distribution (131) en communication avec la pluralité d'espaces de refroidissement liquide (101), une unité de commande de fluide (132), et une pluralité d'unités de distribution de fluide (133), et dans lequel l'unité de commande de fluide (132) et la pluralité d'unités de distribution de fluide (133) sont agencées sur la canalisation de distribution (131), la pluralité d'unités de distribution de fluide (133) sont en correspondance biunivoque avec la pluralité d'espaces de refroidissement liquide (101), chaque unité de distribution de fluide de la pluralité d'unités de distribution de fluide (133) est configurée pour distribuer le fluide de refroidissement à un espace de refroidissement liquide (101) respectif, et l'unité de commande de fluide (132) est configurée pour commander une quantité du fluide de refroidissement distribuée par chaque unité de distribution de fluide (133) à l'espace de refroidissement liquide (101) respectif et pour régler un niveau de liquide dans l'espace de refroidissement liquide (101) respectif, **caractérisé en ce que**
la canalisation d'entrée de liquide (121) et la canalisation de sortie de liquide (123) sont agencées sur l'une de deux surfaces latérales du corps de boîtier (11) s'étendant le long d'une première direction ou sont agencées sur les deux surfaces latérales, respectivement, et la première direction est perpendiculaire à une direction d'agencement d'une pluralité de cellules (211) de l'au moins un module de batterie (21) respectif ; et
**en ce que**
la structure de circulation de fluide (12) comprend une pluralité de canalisations d'écoulement en série (122), chaque canalisation d'écoulement en série de la pluralité de canalisations d'écoulement en série (122) est configurée pour mettre en communication deux espaces de refroidissement liquide respectifs de la pluralité d'espaces de refroidissement liquide (101) qui sont adjacents dans la direction prédéterminée, et la pluralité de canalisations d'écoulement en série (122) sont agencées en alternance sur les deux surfaces latérales du corps de boîtier (11).

2. Dispositif de refroidissement liquide par immersion selon la revendication 1, **caractérisé en ce que** la structure de circulation de fluide (12) comprend une pluralité de canalisations d'entrée de liquide (121), une pluralité de canalisations de sortie de liquide (123), et une pluralité de canalisations d'écoulement en série (122) qui sont agencées à intervalles le long de la première direction, respectivement.

3. Dispositif de refroidissement liquide par immersion selon la revendication 1, **caractérisé en ce que** le corps de boîtier (11) comprend un cadre (111), des parois (112) agencées sur le cadre (111) et formant un espace clos, et des séparateurs (113) divisant l'espace clos en la pluralité d'espaces de refroidissement liquide (101), et dans lequel le cadre (111) a une pluralité de plateformes (102) en correspondance biunivoque avec la pluralité d'espaces de refroidissement liquide (101), chaque plateforme de la pluralité de plateformes (102) a une zone creuse respective et est configurée pour supporter l'au moins un module de batterie (21) respectif et séparer l'au moins un module de batterie (21) respectif d'un séparateur correspondant des séparateurs (113).

4. Dispositif de refroidissement liquide par immersion selon la revendication 3, **caractérisé en ce que** le cadre (111) comprend une pluralité de colonnes (1111) en butée sur les parois (112), respectivement, une pluralité d'ensembles de tiges de liaison (1112) agencés le long de la direction prédéterminée et reliés respectivement à la pluralité de colonnes (1111), et des ensembles de tiges intermédiaires (1113) en correspondance biunivoque avec la pluralité d'espaces de refroidissement liquide (101) ; et
dans lequel chaque ensemble de tiges intermédiaires des ensembles de tiges intermédiaires (1113) est relié à un ensemble de tiges de liaison respectif de la pluralité d'ensembles de tiges de liaison (1112) et comprend une pluralité respective de tiges intermédiaires agencées à intervalles et configurées pour supporter l'au moins un module de batterie (21) respectif, et une direction d'extension de la pluralité respective de tiges intermédiaires est parallèle à une direction d'agencement d'une pluralité de cellules (211) de l'au moins un module de batterie (21) respectif.

5. Dispositif de refroidissement liquide par immersion selon la revendication 4, **caractérisé en ce que** le cadre (111) comprend en outre des ensembles de nervures de renfort (1114) en correspondance biunivoque avec la pluralité d'espaces de refroidissement liquide (101), dans lequel chaque ensemble de nervures de renfort des ensembles de nervures de renfort (1114) est relié à un ensemble de tiges intermédiaires respectif des ensembles de tiges intermédiaires (1113) et comprend une pluralité respective de nervures de renfort agencées à intervalles, et chaque nervure de renfort de la pluralité respective de nervures de renfort est affleurante avec ou plus basse que la pluralité respective de tiges intermédiaires dans la direction prédéterminée.

6. Dispositif de refroidissement liquide par immersion selon l'une quelconque des revendications 3 à 5, **caractérisé en ce qu'**il comprend en outre des canaux agencés à l'intérieur des parois (112), dans lequel les canaux sont configurés pour l'écoulement du fluide de refroidissement, et chacun des canaux a une forme incurvée respective.

7. Dispositif de refroidissement liquide par immersion selon l'une quelconque des revendications 3 à 6, **caractérisé en ce qu'**il comprend en outre des composants de dissipation de chaleur agencés sur des surfaces des parois (112) ou agencés à l'intérieur des parois (112).

8. Dispositif de refroidissement liquide par immersion selon l'une quelconque des revendications 3 à 7, **caractérisé en ce que** chaque séparateur des séparateurs (113) a des rainures respectives formées sur une surface respective de chaque séparateur (113) portant le fluide de refroidissement, et les rainures respectives sont configurées pour l'écoulement du fluide de refroidissement ; et
dans lequel chaque rainure des rainures respectives a une forme incurvée respective ou s'étend le long d'un trajet incurvé respectif.

9. Dispositif de refroidissement liquide par immersion selon la revendication 5, **caractérisé en ce que** chaque ensemble de nervures de renfort des ensembles de nervures de renfort (1114) comprend des premières nervures de renfort respectives et des secondes nervures de renfort respectives, et les premières nervures de renfort respectives ont une direction d'extension différente d'une direction d'extension des secondes nervures de renfort respectives.

10. Dispositif de refroidissement liquide par immersion selon la revendication 1, **caractérisé en ce que** la structure de circulation de fluide (12) comprend en outre une canalisation de réapprovisionnement en liquide (124), et la canalisation de réapprovisionnement en liquide (124) et la canalisation d'entrée de liquide (121) sont reliées à un même espace de refroidissement liquide de la pluralité d'espaces de refroidissement liquide (101).

11. Dispositif de refroidissement liquide par immersion selon l'une quelconque des revendications 1 à 10, **caractérisé en ce que** chaque unité de distribution de fluide de la pluralité d'unités de distribution de fluide (133) est une électrovanne, un robinet d'étranglement, ou une vanne de régulation de débit à ouverture réglable, et l'unité de commande de fluide (132) est une pompe.

12. Système de stockage d'énergie comprenant :
une pluralité de modules de batterie (21), dans lequel chaque module de batterie de la pluralité de modules de batterie (21) comprend une pluralité respective de cellules (211) ; et **caractérisé par** :
le dispositif de refroidissement liquide par immersion selon l'une quelconque des revendications 1 à 11, dans lequel chaque espace de refroidissement liquide de la pluralité d'espaces de refroidissement liquide (101) du corps de boîtier (11) est configuré pour recevoir l'au moins un module de batterie respectif de la pluralité de modules de batterie (21).

13. Procédé de gestion thermique, appliqué au dispositif de refroidissement liquide par immersion selon l'une quelconque des revendications 1 à 11, comprenant :
l'injection (S100) du fluide de refroidissement dans la pluralité d'espaces de refroidissement liquide (101) du corps de boîtier (11) par l'intermédiaire de la structure de circulation de fluide (12) jusqu'à ce qu'un niveau de liquide du fluide de refroidissement atteigne un niveau de liquide initial ;
la détection (S200) de températures d'une pluralité de cellules (211) de l'au moins un module de batterie (21) respectif dans chaque espace de refroidissement liquide de la pluralité d'espaces de refroidissement liquide (101) ;
en réponse au fait que les températures de la pluralité de cellules (211) sortent d'une plage de seuil, l'élévation (S300) du niveau de liquide du fluide de refroidissement dans la pluralité d'espaces de refroidissement liquide (101) en commandant la pluralité d'unités de distribution de fluide (133) pour distribuer à l'aide de l'unité de commande de fluide (132) ; et
en réponse au fait que les températures de la pluralité de cellules (211) ne sortent pas de la plage de seuil, le maintien (S300) du niveau de liquide du fluide de refroidissement dans la pluralité d'espaces de refroidissement liquide (101) au niveau de liquide initial.
